(19) Europäisches Patentamt European Patent Office Office européen des brevets

(11) **EP 4 366 163 A2**

(12) **EUROPEAN PATENT APPLICATION**

(43) Date of publication:
**08.05.2024 Bulletin 2024/19**

(21) Application number: **23207140.7**

(22) Date of filing: **31.10.2023**

(51) International Patent Classification (IPC):
**H03F 3/195** $^{(2006.01)}$   **H03F 3/45** $^{(2006.01)}$

(52) Cooperative Patent Classification (CPC):
**H03F 3/45475; H03F 3/195;** H03F 2203/45544;
H03F 2203/45551; H03F 2203/45586

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **02.11.2022  US 202263381939 P**
**28.09.2023  US 202318477538**

(71) Applicant: **MediaTek Inc.**
**30078 Hsinchu City (TW)**

(72) Inventors:
• **ELSHATER, Ahmed Othman Mohamed Mohamed**
**San Jose (US)**
• **AWAD, Ramy**
**San Jose (US)**
• **ALI, Tamer Mohammed**
**San Jose (US)**

(74) Representative: **Wright, Howard Hugh Burnby Withers & Rogers LLP**
**2 London Bridge**
**London SE1 9RA (GB)**

(54) **DIFFERENTIAL ALL-PASS COUPLING CIRCUIT WITH COMMON MODE FEEDBACK**

(57)    A differential all-pass coupling circuit with common mode feedback is disclosed. An example apparatus includes an anti-aliasing circuit configured to reduce a bandwidth of a first differential signal, and a switched-capacitor circuit coupled to the anti-aliasing circuit configured to control a first switch to charge a capacitor to a first voltage based on a first difference between (i) a common mode input voltage associated with a first common mode voltage of the first differential signal and (ii) a common mode reference voltage associated with a second common mode voltage of an input stage of the receiver, control a second switch to provide a second voltage to the capacitor based on a second difference between the first differential signal and the common mode input voltage, and output a second differential signal to the input stage based on the first differential signal adjusted by the second voltage.

FIG. 3

EP 4 366 163 A2

**Description**

FIELD OF THE DISCLOSURE

The technology disclosed herein relates to signal processing, and in particular to a differential all-pass coupling circuit with common mode feedback.

BACKGROUND

Receivers, such as wireline signal receivers, are devices that may receive electromagnetic signals. The electromagnetic signals may include high-frequency and low-frequency signal components. Some wireline signal receivers may have alternating current (AC) coupling circuits to allow the high-frequency signal components to pass through a connection while the low-frequency signal components are attenuated.

SUMMARY

Some aspects relate to an apparatus comprising an anti-aliasing circuit configured to reduce a bandwidth of a first differential signal received from a termination circuit of a receiver; and a switched-capacitor circuit coupled to an output of the anti-aliasing circuit, the switched-capacitor circuit configured to: control a first switch to charge a capacitor to a first voltage, wherein the first voltage is based on a first difference between a common mode input voltage and a common mode reference voltage, the common mode input voltage associated with a first common mode voltage of the first differential signal, the common mode reference voltage associated with a second common mode voltage of an input stage of the receiver; control a second switch to provide a second voltage to the capacitor, the second voltage based on a second difference between the first differential signal and the common mode input voltage; and output a second differential signal to the input stage of the receiver, the second differential signal based on the first differential signal adjusted by the second voltage.

Some aspects relate to another apparatus comprising coil circuitry configured to receive a first differential signal; input stage circuitry; and alternating current coupling circuitry coupled to an output of the coil circuitry, the alternating current coupling circuitry configured to: charge a capacitor to a first voltage, the first voltage based on a first difference between a common mode input voltage and a common mode reference voltage, the common mode input voltage associated with a first common mode voltage of the first differential signal, the common mode reference voltage associated with a second common mode voltage of the input stage circuitry; provide a second voltage to the capacitor, the second voltage based on a second difference between the first differential signal and the common mode input voltage; and output a second differential signal to the input stage circuitry, the second differential signal adjusted by the second voltage; and wherein the input stage circuitry is configured to convert the second differential signal to a third differential signal.

Some aspects relate to a method comprising sensing an output common mode voltage associated with a differential signal of an input stage of a receiver; determining a difference between the sensed output common mode voltage and a target output common mode voltage; determining whether the difference satisfies a threshold; and in response to determining that the difference satisfies the threshold, outputting a voltage to an all-pass circuit to adjust the output common mode voltage.

BRIEF DESCRIPTION OF DRAWINGS

In the drawings, each identical or nearly identical component that is illustrated in various figures is represented by a like reference character. For purposes of clarity, not every component may be labeled in every drawing. The drawings are not necessarily drawn to scale, with emphasis instead being placed on illustrating various aspects of the techniques and devices described herein.

FIG. 1 is a schematic illustration of an example receiver system, which includes an alternating current (AC) coupling circuit to filter a signal provided to a receiver input stage.

FIG. 2 is a schematic illustration of an example implementation of an AC coupling circuit, which includes an all-pass circuit including an anti-aliasing low-pass filter and a switched-capacitor signal-processing circuit.

FIG. 3 is a schematic illustration of example implementations of the anti-aliasing low-pass filter and the switched-capacitor signal-processing circuit of FIG. 2.

FIG. 4 is a schematic illustration of example effective filters seen by an input differential signal through the all-pass circuit of FIGS. 2 and/or 3.

FIG. 5 is a timing diagram that depicts example waveforms associated with the switched-capacitor signal processing circuit of FIGS. 2 and/or 3.

FIG. 6 is a schematic illustration of another example implementation of the switched-capacitor signal-processing circuit of FIG. 2, which utilizes a differential sampling technique.

FIG. 7 is a timing diagram that depicts example waveforms associated with the switched-capacitor signal processing circuit of FIG. 6.

FIG. 8 is a schematic illustration of yet another example implementation of the switched-capacitor signal-processing circuit of FIG. 2, which implements a positive-charge pump.

FIG. 9 is a schematic illustration of another example implementation of the AC coupling circuit of FIGS. 1 and/or 2, which includes a clocked comparator.

FIG. 10 is a timing diagram that depicts example waveforms associated with the AC coupling circuit of FIG. 9.

FIG. 11 is a schematic illustration of yet another example implementation of the AC coupling circuit of FIGS. 1 and/or 2, which includes a multiplexer controlled by a clock signal.

FIG. 12 is a schematic illustration of an example implementation of a clock circuit to generate the clock signal of FIG. 11.

FIG. 13 is a plot that depicts a waveform representing a power spectral density of the clock signal of FIGS. 11 and/or 12.

FIG. 14 is a flowchart of an example method to adjust an output common mode based on common mode feedback.

DETAILED DESCRIPTION

Some devices may use receivers, such as wireline signal receivers, to receive and/or process electromagnetic signals. For example, a data receiving device may include a receiver that uses a T-coil through which input data propagates. The T-coil may include two coils with a mutual inductance between them and configured for input bandwidth extension. The T-coil may output an alternating signal that includes high-frequency signal components and low-frequency signal components.
Some receivers may use an alternating current (AC) coupling circuit to allow high-frequency signal components of a signal to pass to a differential amplifier (e.g., a fully differential amplifier) of the receivers and direct current (DC) and/or low-frequency signal components of the signal to be attenuated. For example, an AC coupling circuit may be configured to operate as a high-pass filter to pass the high-frequency signal components to the differential amplifier and suppress the DC and/or low-frequency signal components.
Some receivers may use the high-pass filter implemented by the AC coupling circuit for input DC common mode rejection. Common mode rejection refers to suppression of signals common to two inputs, such as differential inputs of a receiver. For example, the AC coupling circuit may effectuate input DC common mode rejection by decoupling an input signal common mode, such as a common mode at terminals that receive a differential signal, from a receiver input common mode, such as a common mode at an input of the differential amplifier.
Some receivers may use the AC coupling circuit to bias a component of the receivers, such as a differential amplifier, using common mode feedback. For example, the AC coupling circuit may be configured to bias the differential amplifier at a particular common mode DC bias voltage such that the differential amplifier may amplify the differential signal as designed. In such an example, the AC coupling circuit may compare the common mode input signal to a reference signal and generate the common mode DC bias voltage based on the comparison.
The inventors have recognized and appreciated that there are several challenges of using AC coupling circuits to implement a high-pass filter. One challenge is that the cut-off frequency (f_AC) of AC coupling needs to be low enough to avoid affecting signal frequency content yet high enough to attenuate the common mode input signal. In some examples, the cut-off frequency is too low, which can allow an increased level of the common mode input signal to reach a receiver component (e.g., a differential amplifier) and thereby reduce the effectiveness of input DC common mode rejection. In some examples, the cut-off frequency is too high, which can cut off signal frequency content of the differential input signal and thereby decrease the signal-to-noise (SNR) ratio associated with the differential input signal.

Another challenge of using an AC coupling circuit as a high-pass filter is that the cut-off frequency typically selected for conventional receivers is approximately 50 kilohertz (kHz). The cut-off frequency may be implemented by using discrete passive components such as capacitors and resistors in a particular circuit arrangement. However, a cut-off frequency of approximately 50 kHz results in a substantially large physical area of a die of a chip, a printed circuit board (PCB), etc., that is consumed by the discrete passive components, which causes enlargement of a physical footprint of the receiver device that includes the chip, the PCB, etc.

Yet another challenge of using an AC coupling circuit as a high-pass filter is avoiding the undesired effect of baseline wandering. In a receiver example, baseline wandering may refer to a differential input signal drifting towards the common mode of the receiver. In such an example, a receiver in a data receiving device may receive data representing a relatively long string of zeros or ones such that the average power of the receiver may skew away from a baseline average power of the receiver. For example, the average power of the receiver may skew higher in response to receiving a relatively long string of ones and data representing zeros may be misinterpreted as ones due to the upshifted average power.

The inventors have also recognized and appreciated that there are several challenges of using AC coupling circuits for common mode feedback. One challenge is supporting a wide common mode range. For example, conventional techniques may utilize cascode current sources for common mode feedback, such as dual-cascode current sources to support both positive and negative common mode shift range, but have challenges as described below.

Another challenge is reducing the supply voltage for operation of the receiver. For example, there is a substantially large voltage headroom across the above-referenced cascode current sources. A higher supply voltage is needed to provide such a large voltage headroom to control the high-voltage cascode current sources. A higher supply voltage may be detrimental in some receivers that are power constrained (e.g., a receiver powered by a battery).

The inventors have recognized and appreciated that the above challenges have not been overcome by conventional AC coupling circuits, and/or, more generally, by conventional receivers. The inventors have developed a differential all-pass coupling circuit with common mode feedback to overcome the above challenges and improve upon conventional AC coupling and/or receiver circuits.

The inventor's differential all-pass coupling circuit disclosed herein passes through a differential input signal and provides common mode feedback control all while supporting a wide voltage range with low power and low area overhead. In some disclosed examples, the differential all-pass coupling circuit can be implemented at least in part using a switched-capacitor signal processing circuit to decouple a differential input signal from a DC signal. For example, the switched-capacitor signal processing circuit can implement an effective switched-capacitor low-pass filter with an operating clock frequency designed for a particular AC coupling bandwidth. Beneficially, the substantial increase in AC coupling bandwidth overcomes the challenge of having the cut-off frequency being too low or too high.

Additionally, the increased AC coupling bandwidth can be substantially greater than the 50 kHz cut-off frequency of conventional AC coupling circuits. For example, the increased AC coupling circuit can result in substantial reductions in die area and/or PCB area compared to conventional AC coupling circuits. In some disclosed examples, the switched-capacitor signal processing circuit can utilize differential sampling to overcome the baseline wandering challenges described above.

Furthermore, the inventor's switched-capacitor signal processing circuit disclosed herein can adjust a common mode of the differential input signal with a feedback signal to generate a desired common mode for a component of a receiver, such as a differential amplifier. In some disclosed examples, the differential all-pass coupling circuit can utilize a dynamic comparator with logic-level feedback to generate the feedback signal. Beneficially, the switched-capacitor signal processing circuit can achieve accurate DC-coupling of differential input signals without using high-impedance cascode current sources and/or high-impedance bias voltage generation techniques. For example, the switched-capacitor signal processing circuit can achieve accurate DC-coupling of differential input signals with a wide voltage range and low power overhead compared to conventional cascode-current source implementations.

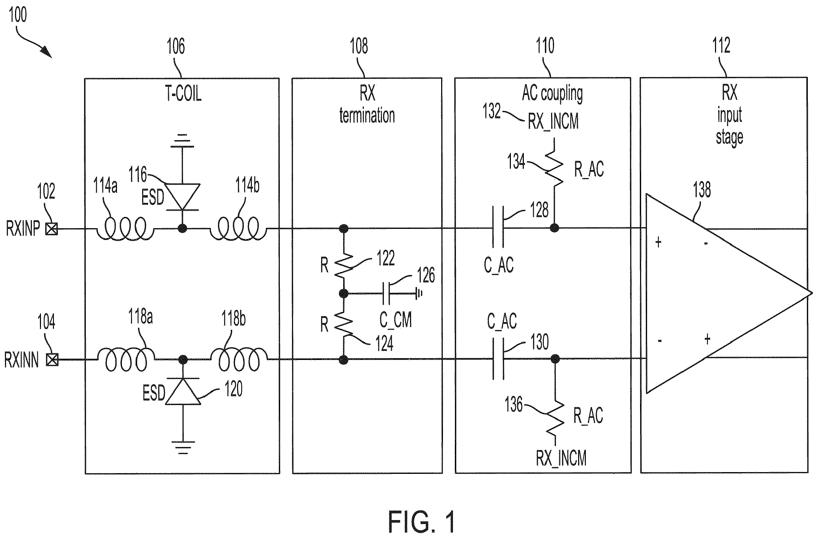

Turning to the figures, FIG. 1 is a schematic illustration of an example receiver system 100 to receive a differential signal from input terminals 102, 104 (identified by RXINP and RXINN, RXINP-RXINN, RXINP/RXINN, or RXINP/N). In some embodiments, the receiver system 100 is a wireline receiver, such as a data communication wireline receiver. Non-limiting examples of wireline receivers include Ethernet interfaces, Peripheral Component Interconnect (PCI) interfaces, Serial Digital Interfaces (SDI), Universal Serial Bus (USB) interfaces, and High-Definition Multimedia Interfaces (HDMI). In some embodiments, the receiver system 100 is a wireless receiver, such as a wireless charging receiver, which can convert received electromagnetic signals into DC signals for charging a device, such as a battery of an electronic device. Non-limiting examples of electronic devices include laptop computers, tablet computers, smartphones, and wearable devices (e.g., headphones, headsets, smartwatches, smart glasses, etc.).

In the illustrated example, the receiver system 100 includes a T-coil circuit 106 (identified by T-COIL), a receiver (RX) termination circuit 108, an AC coupling circuit 110, and an RX input stage circuit 112. Alternatively, the receiver system 100 may not include one(s) of the T-coil circuit 106, the RX termination circuit 108, the AC coupling circuit 110, and/or the RX input stage circuit 112. In the illustrated example, output(s) of the T-coil circuit 106 is/are coupled to input(s) of the RX termination circuit 108. For example, output(s) of the T-coil circuit 106 is/are coupled to input(s) of the RX termination circuit 108 through one or more electrical connections. Non-limiting examples of electrical connections include opto-isolators, pads, traces, wires, and vias. In the illustrated example, output(s) of the RX termination circuit 108 is/are coupled to input(s) of the AC coupling circuit 110. In the illustrated example, output(s) of the AC coupling circuit 110 is/are coupled to input(s) of the RX input stage circuit 112.

In some embodiments, the receiver system 100 is implemented by one or more integrated circuits (ICs) (e.g., one or more monolithic ICs, one or more chips). For example, the T-coil circuit 106, the RX termination circuit 108, the AC coupling circuit 110, and the RX input stage circuit 112 can be included in the same chip. Alternatively, one or more of the T-coil circuit 106, the RX termination circuit 108, the AC coupling circuit 110, and/or the RX input stage circuit 112 may be implemented by separate ICs. For example, the T-coil circuit 106 can be implemented by a first chip, the RX termination circuit 108 can be implemented by a second chip, the AC coupling circuit 110 can be implemented by a third chip, and the RX input stage circuit 112 can be implemented by a fourth chip.

In some embodiments, one(s) of the T-coil circuit 106, the RX termination circuit 108, the AC coupling circuit 110, and/or the RX input stage circuit 112 can be combined using different combinations of chips. For example, the T-coil circuit 106 and the RX termination circuit 108 can be implemented by a first chip and the AC coupling circuit 110 and the RX input stage circuit 112 can be implemented by a second chip, different from the first chip. Any other combinations of the T-coil circuit 106, the RX termination circuit 108, the AC coupling circuit 110, and/or the RX input stage circuit 112 into one or more ICs are contemplated.

In some embodiments, the receiver system 100 includes the input terminals 102, 104 to receive a differential signal (e.g., a differential signal of RXINP and RXINN (RXINP/RXINN)) For example, the input terminals 102, 104 can be pads, leads, legs, or vias of IC(s), chip(s), PCB(s), etc., that implement the receiver system 100. In some embodiments, the receiver system 100 does not include the input terminals 102, 104. For example, the T-coil circuit 106 can include terminals that respectively couple to the input terminals 102, 104, which may be associated with a different IC, chip, or system.

In some embodiments, the receiver system 100 of the illustrated example includes the T-coil circuit 106 to convert electromagnetic signals received from the input terminals 102, 104 to alternating signals, which are output to the RX termination circuit 108. For example, the T-coil circuit 106 can implement coil circuitry to convert the electromagnetic signals to the alternating signals. The T-coil circuit 106 includes a first pair of inductors 114a, 114b coupled to a first electrostatic discharge (ESD) diode 116. The T-coil circuit 106 includes a second pair of inductors 118a, 118b coupled to a second ESD diode 120. In the illustrated example, a first inductor 114a of the first pair of inductors 114a, 114b is coupled to a first input terminal 102 (identified by RXINP) of the input terminals 102, 104. In the illustrated example, a first inductor 118a of the second pair of inductors 118a, 118b is coupled to a second input terminal 104 (identified by RXINN) of the input terminals, 102, 104. In some embodiments, the first and second ESD diodes 116, 120 are diodes coupled to the inductors 114a, 114b, 118a, 118b in such an arrangement to provide ESD protection to the T-coil circuit 106, and/or, more generally, the receiver system 100.

In some embodiments, the inductors 114a, 114b, 118a, 118b create oscillating magnetic fields in response to the electromagnetic signals received from the input terminals 102, 104. In some embodiments, the inductors 114a, 114b, 118a, 118b convert the oscillating magnetic fields to alternating signals, which may have AC and/or DC components. In some embodiments, the inductors 114a, 114b, 118a, 118b output the alternating signals to the RX termination circuit 108.

In some embodiments, the receiver system 100 of the illustrated example includes the RX termination circuit 108 to prevent reflections of the alternating signals received from the T-coil circuit 106 back to the T-coil circuit 106. For example, the T-coil circuit 106 and the RX termination circuit 108 can be configured to provide a matching network for the input channels RXINP and RXINN.

In the illustrated example, the RX termination circuit 108 includes first resistors 122, 124 (identified by R) coupled in parallel to a first capacitor 126 (identified by C_CM). For example, the first capacitor 126 may be a common mode (CM) capacitor, such as a capacitor that is configured to store a common mode voltage (e.g., a common mode input voltage) associated with the input terminals 102, 104. For example, C_CM 126 may store a common mode voltage associated with the differential signal (RXINP/RXINN). In the illustrated example, the resistances of the first resistors 122, 124 are the same. For example, the respective resistances of the first resistors 122, 124 can be 50 ohms ($\Omega$). Alternatively, the first resistors 122, 124 may have any other resistance. In some embodiments, the first resistors 122, 124 may have a different resistance from each other.

In some embodiments, the receiver system 100 of the illustrated example includes the AC coupling circuit 110 for input DC common mode rejection. For example, the AC coupling circuit 110 can implement AC coupling circuitry to reject the input DC common mode. For example, the AC coupling circuit 110 can be configured to decouple the input signal common mode from the RX input common mode. In this example, the input signal common mode can be represented by a voltage across C_CM 126. For example, the voltage that is common to both input terminals 102, 104 may generate the voltage across C_CM 126. In this example, the RX input common mode can be represented by a voltage across the inputs of the RX input stage circuit 112.

The AC coupling circuit 110 of the illustrated example includes second capacitors 128, 130 (e.g., blocking capacitors, DC blocking capacitors) (identified by C_AC) configured to decouple the input signal common mode from the RX input common mode. For example, C_AC 128, 130 may block (e.g., reject) DC and/or low-frequency components of a differential signal received by the input terminals 102, 104 (e.g., a differential signal represented by RXINP/RXINN).

In some embodiments, the receiver system 100 of the illustrated example includes the AC coupling circuit 110 for common mode feedback, such as common mode feedback control. For example, the AC coupling circuit 110 can receive a bias voltage 132 (identified by RX_INCM) that may be generated in response to a comparison of the common mode voltage (e.g., the voltage across C_CM 126) and a common mode reference voltage. In some embodiments, the AC coupling circuit 110 can inject the bias voltage 132 into the inputs of the RX input stage circuit 112 via second resistors 134, 136 (identified by R_AC). In the illustrated example, R_AC 134, 136 are coupled in parallel with C_AC 128, 130 and the inputs of the RX input stage circuit 112. For example, C_AC 128 is coupled in parallel with R_AC 134. In this example, R_AC 134 is coupled in parallel with a first input of a differential amplifier 138 of the RX input stage circuit 112.

In some embodiments, the AC coupling circuit 110 implements a first-order high-pass filter with a high-pass cut-off frequency (f_AC) as illustrated by the example of Equation (1) below:

$$f\_AC = \frac{1}{Rac*(Cac+CL)}, Equation \ (1)$$

In the example of Equation (1) above, Rac is the resistance of one of R_AC 134, 136, Cac is the capacitance of one of C_AC 128, 130, and CL represents the capacitive loading of the RX input stage circuit 112. In some embodiments, the AC coupling circuit 110 attenuates an input signal having a frequency below f_AC.

In some embodiments, the AC coupling circuit 110 can be configured to use the bias voltage 132 to bias a component of the RX input stage circuit 112, such as the differential amplifier 138. For example, the AC coupling circuit 110 can inject the bias voltage 132 into the inputs of the differential amplifier 138 to ensure that the input voltage of the differential amplifier 138 is maintained in a specified range. The differential amplifier 138 of this example is a fully differential amplifier. Alternatively, the RX input stage circuit 112 may be configured to use a different type of amplifier and/or a different number of amplifiers.

In some embodiments, the receiver system 100 includes the RX input stage circuit 112 to output a differential output signal based on a differential input signal. For example, the differential output signal from the RX input stage circuit 112 can be provided to other circuitry for additional processing, such as converting the differential output signal into digital data (e.g., data representing a logic zero, data representing a logic one, Ethernet data, serial data, etc.) for use by a downstream device (e.g., a computer-hardware processor, a digital signal processor, a network interface device, etc.).

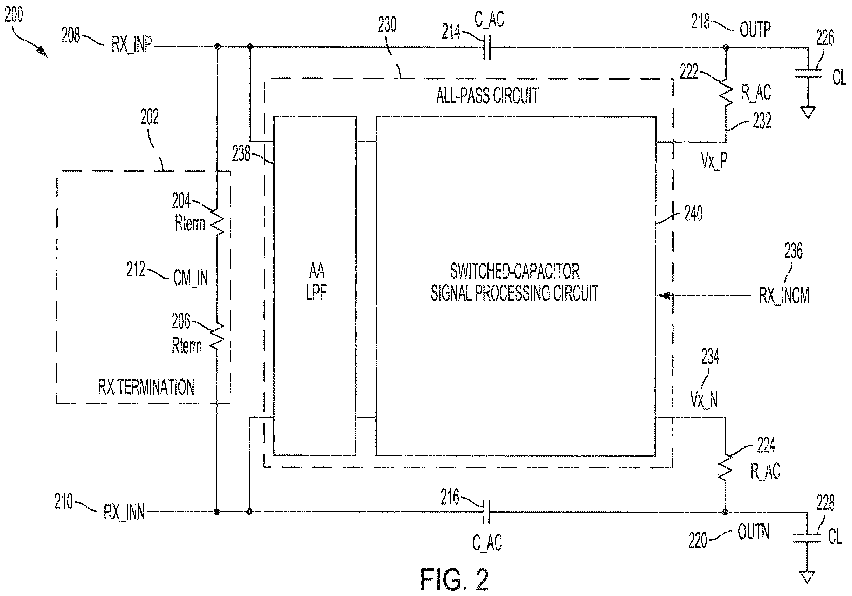

FIG. 2 is a schematic illustration of an example implementation of an AC coupling circuit 200. In some embodiments, the AC coupling circuit 200 can implement the AC coupling circuit 110 of FIG. 1. The AC coupling circuit 200 of FIG. 2 is coupled to an example implementation of an RX termination circuit 202. The RX termination circuit 202 of this example includes first resistors 204, 206 (identified by Rterm) coupled together in series. Rterm 204, 206 are coupled in parallel to respective inputs that provide input signals 208, 210 (identified by RX_INP and RX_INN). In the illustrated example, a common mode input voltage 212 (identified by CM_IN) of the input signals 208, 210 is represented as a voltage between Rterm 204, 206. In some embodiments, the input signals 208, 210 correspond to RXINP and RXINN of FIG. 1, respectively.

In some embodiments, the RX termination circuit 202 of FIG. 2 can implement the RX termination circuit 108 of FIG. 1. For example, Rterm 204, 206 of FIG. 2 may correspond to R 122, 124 of FIG. 1. In some embodiments, CM_IN 212 may correspond to the voltage across C_CM 126 of FIG. 1.

In the illustrated example, the DC components of the input signals 208, 210 may be blocked by first capacitors 214, 216 (identified by C_AC). In some embodiments, C_AC 214, 216 of FIG. 2 may correspond to C_AC 128, 130 of FIG. 1. In some embodiments, the AC components of the input signals 208, 210 may propagate through C_AC 214, 216 and output as output signals 218, 220 (identified by OUTP and OUTN). In some embodiments, C_AC 214, 216 and second resistors 222, 224 (identified by R_AC) may establish a first-order high-pass filter. Further depicted in FIG. 2 are second capacitors 226, 228 (identified by CL), which are representative of the capacitive loading of additional circuitry, such as the RX input stage circuit 112 of FIG. 1.

The AC coupling circuit 200 of the illustrated example includes an all-pass circuit 230 to provide voltages Vx_P 232 and Vx_N 234 such that the following conditions are satisfied: (1) a differential signal (RX_INN-RX_INN) is passed through the AC coupling circuit 200 for frequencies up to approximately 10*f_AC such that:

*Vx_P - Vx_N = RX_INP - RX_INN;* and (2) a bias voltage 236 (identified by RX_INCM) is provided such that: *RX_INCM = (Vx_P + Vx_N)/2;* all while supporting a wide voltage range with low power and low area overhead. For example, the all-pass circuit 230 can be an all-pass filter configured such that the differential signal is passed through the AC coupling circuit 200 without affecting the high-frequency components of the input signals 208, 210. For example, the all-pass circuit 230 can be configured such that the common mode input of the RX input stage circuit 112 of FIG. 1 can be provided as feedback to generate RX_INCM 236.

In the illustrated example, the all-pass circuit 230 includes an anti-aliasing low-pass filter 238 (identified by AA LPF) and a switched-capacitor signal processing circuit 240. In some embodiments, the AC coupling circuit 200 includes the anti-aliasing low-pass filter 238 to provide anti-aliasing for the switched-capacitor signal processing circuit 240. For example, the anti-aliasing low-pass filter 238 can be an anti-aliasing circuit configured to perform anti-aliasing on the input signals 208, 210 to reduce a bandwidth of the differential signal.

In some embodiments, the AC coupling circuit 200 includes the switched-capacitor signal-processing circuit 240 (or simply the switched-capacitor circuit) to extract the differential signal from DC for frequencies up to approximately 10 times the AC coupling bandwidth. In some embodiments, the switched-capacitor signal-processing circuit 240 adds RX_INCM 236 to Vx_P 232 and Vx_N 234 to set the common mode to OUTP/OUTN, which can ensure proper operation of downstream circuitry, such as the differential amplifier 138 of FIG. 1.

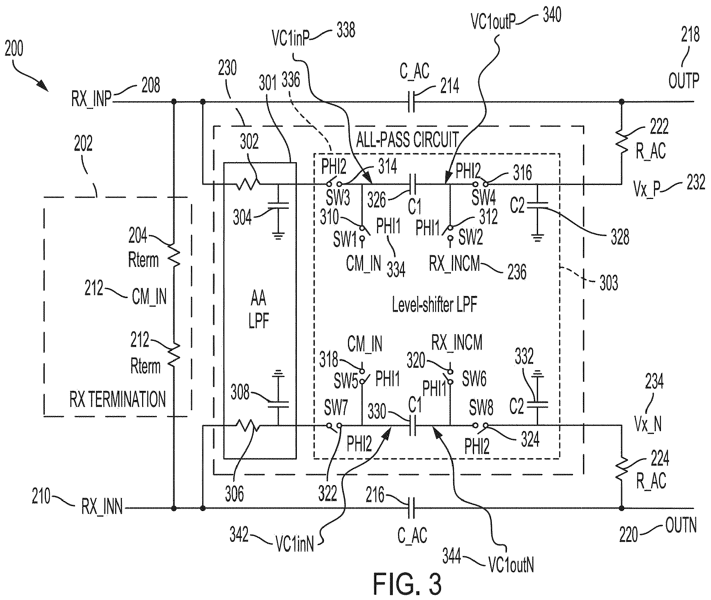

FIG. 3 is a schematic illustration of example implementations of the anti-aliasing low-pass filter 238 and the switched-capacitor signal-processing circuit 240 of FIG. 2. For example, FIG. 3 depicts an anti-aliasing low-pass filter 301, which may implement the anti-aliasing low-pass filter 238 of FIG. 2. FIG. 3 depicts a level-shifter low-pass filter (LPF) circuit 303, which may implement the switched-capacitor signal-processing circuit 240 of FIG. 2.

In the illustrated example, the anti-aliasing low-pass filter 301 is implemented by RC networks. For example, the anti-aliasing low-pass filter 301 includes a first RC network implemented by a first resistor 302 coupled in parallel with a first capacitor 304. The anti-aliasing low-pass filter 301 includes a second RC network implemented by a second resistor 306 coupled in parallel with a second capacitor 308. The first resistor 302 is coupled in parallel with a first terminal to receive RX_INP 208 and is coupled in parallel with C_AC 214 of the first capacitors 214, 216. In the illustrated example, the second resistor 306 is coupled in parallel with a second terminal to receive RX_INN 210 and is coupled in parallel with C_AC 216 of the first capacitors 214, 216.

In some embodiments, the level-shifter LPF circuit 303 can charge the Vx_P 232 and Vx_N 234 nodes to the differential input (RXINP-RXINN) with a desired output common mode (e.g., RX_INCM 236) in two clock cycles. Alternatively, the number of clock cycles to charge the Vx_P 232 and Vx_N 234 nodes to the differential input (RXINP-RXINN) can be based on the ratio of the capacitances of C1 326, 330 and C2 328, 332, which are shown in FIG. 3.

The level-shifter LPF circuit 303 of this example includes a first switch 310 (identified by SW1), a second switch 312 (identified by SW2), a third switch 314 (identified by SW3), a fourth switch 316 (identified by SW4), a fifth switch 318 (identified by SW5), a sixth switch 320 (identified by SW6), a seventh switch 322 (identified by SW7), and an eighth switch 322 (identified by SW8). In some embodiments, the switches 310, 312, 314, 316, 318, 320, 322, 324 are implemented by transistors. Non-limiting examples of transistors include a field-effect transistor (FET), a bipolar junction transistor (BJT) (e.g., an NPN BJT, a PNP BJT), and an insulated-gate bipolar transistor (IGBT). Non-limiting examples of FETs include power FETs and metal-oxide-semiconductor field-effect transistors (MOSFETs) (e.g., p-channel MOSFETs, n-channel MOSFETs, etc.). Any other type of transistor is contemplated.

In the illustrated example, SW1 310 is coupled in parallel with SW3 314 and a first capacitor 326 (identified by C1). SW2 312 is coupled in parallel with C1326 and SW4 316. SW4 316 is coupled in parallel with a second capacitor 328 (identified by C2) and R_AC 222 of the second resistors 222, 224.

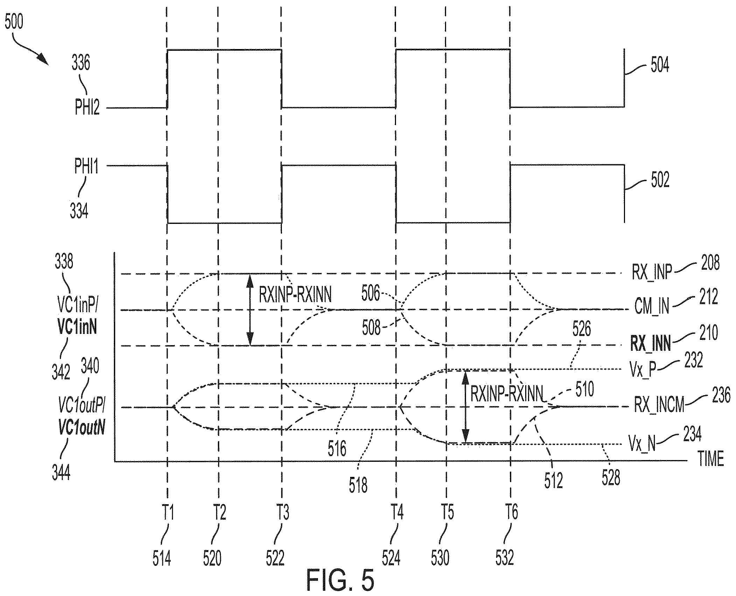

In the illustrated example, SW5 318 is coupled in parallel with SW7 322 and a third capacitor 330 (identified by C1). SW6 320 is coupled in parallel with C1330 and SW8 324. SW8 324 is coupled in parallel with a fourth capacitor 332 (identified by C2) and R_AC 224 of the second resistors 222, 224. Further depicted in FIG. 3 are nodes VClinP 338, VCloutP 340, VClinN 342, and VCloutN 344, which are described in further detail below in connection with FIG. 5.

In example operation, the switches 310, 312, 314, 316, 318, 320, 322, 324 are controlled by a first clock signal 334 (identified by PHI1) and/or a second clock signal 336 (identified by PHI2) to perform discrete-time signal-processing of the input signals 208, 210. In some embodiments, PHI1 334 and PHI2 336 are inverted such that a rising edge of PHI1 334 occurs with a falling edge of PHI2 336 and vice versa. For example, during a first time period associated with PHI1 334, SW1 310 and SW2 312 can be closed and SW3 314 and SW4 316 can be open. In this example, SW1 310 and SW2 312 are closed to charge C1 326 with a first voltage based on a difference between CM_IN 212 and RX_INCM 236. For example, the first voltage can represent a difference between the input voltage common mode and feedback of the difference between the input voltage common mode and a reference voltage common mode (e.g., a target voltage common mode).

In example operation, during a second time period associated with PHI2 336, SW1 310 and SW2 312 are open and SW3 314 and SW4 316 are closed. During the second time period, a first voltage step based on a first difference between RX_INP 208 and CM_IN 212 is applied to a first plate of C1 326 (e.g., the plate of C1 326 coupled to SW1 310 and SW3 314). During the second time period, a second voltage step based on a second difference between RX_INN 210 and CM_IN 212 is applied to a first plate of C1330 (e.g., the plate of C1330 coupled to SW5 318 and SW7 322).

After the first time period and the second time period, the differential input couples through to Vx_P 232 and Vx_N 234. Beneficially, the input voltage common mode can be partially or fully rejected because RX_INP/N 208, 210 and Vx_P/N 232, 234 are at the same common mode.

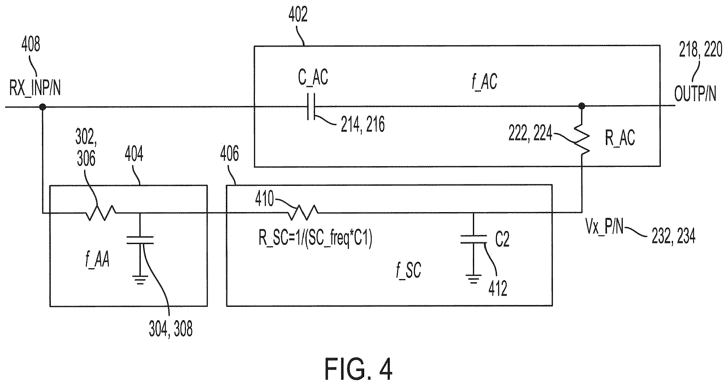

FIG. 4 is a schematic illustration of example effective filters 402, 404, 406 seen by an input differential signal 408 (identified by RX_INP/N) through the all-pass circuit 230 of FIGS. 2 and/or 3. In the illustrated example of FIG. 4, a first effective filter 402 represents a high-pass filter implemented by C_AC 214, 216 of FIGS. 2 and/or 3 coupled in parallel with R_AC 222, 224 of FIGS. 2 and/or 3. For example, the high-pass filter can have a cut-off frequency of f_AC.

In the illustrated example, a second effective filter 404 represents an anti-aliasing filter with a cut-off frequency of f_AA. For example, the anti-aliasing filter can be a low-pass filter implemented by the first resistor 302 and the first capacitor 304 of FIG. 3 (or the second resistor 306 and the second capacitor 308 of FIG. 3).

In the illustrated example, a third effective filter 406 represents a low-pass filter with a cut-off frequency of f_SC. For example, the low-pass filter can be implemented by the level-shifter LPF circuit 303 of FIG. 3 and is represented in FIG. 4 by an RC network. In this example, the RC network is implemented by an effective resistor 410 (identified by R_SC) determined by Equation (2) below:

$$R\_SC = 1/(SC\_freq * C1), Equation\ (2)$$

In the example of Equation (2) above, C1 is the capacitance of C1 326 (or C1 330) of FIG. 3 and SC_freq is an operating clock frequency. For example, SC_freq can be the operating clock frequency of the level-shifter LPF circuit 303, and/or, more generally, the switched-capacitor signal processing circuit 240 of FIG. 2.

In some embodiments, the level-shifter LPF circuit 303 can be configured to achieve substantial reductions in die area and/or PCB area. For example, f_AC can represent the AC coupling bandwidth and can be represented by Equation (3) below:

$$f\_AC = 1/(2 * \pi * R\_AC * C\_AC), Equation\ (3)$$

In some embodiments, f_SC is to be wider than f_AC to pass the low-frequency signal to OUTP/N 218, 220. For example, f_SC can be represented by Equation (4) below:

$$f\_SC = 1/(2 * \pi * R\_SC * C2), Equation\ (4)$$

Combining Equation (2) and Equation (4) above results in Equation (5) below:

$$f\_SC = (1/(2 * \pi)) * SC\_freq * (C1/C2), Equation\ (5)$$

If the ratio of C2/C1 is assumed to be 5, then Equation (5) above results in Equation (6) below:

$$SC\_freq = f\_SC/(0.16 * 1/5) = 30 * f\_SC > 150 * f\_AC, Equation\ (6)$$

In some embodiments, SC_freq can be designed for a particular AC coupling bandwidth using the examples of Equations (1)-(6) above. For example, if SC_freq is assumed to be 350 megahertz (MHz), then f_SC becomes approximately 12 MHz (e.g., ~12 MHz = 350 MHz / 30). Beneficially, f_AC can correspondingly be designed at 2.4 MHz (e.g., 2.4 MHz = 12 MHz / 5). When compared to passive AC coupling that utilizes a cut-off frequency of 50 kHz, f_AC designed at 2.4 MHz represents an approximately 50 times increase in cut-off frequency. Beneficially, such a substantial increase in cut-off frequency can yield an approximately 7 times reduction in die area and/or PCB area. For example, a 7 times reduction in RC area can be achieved assuming R and C overlap in area.

In some embodiments, f_AA can also be designed to accommodate f_AC of 2.4 MHz. For example, f_AA can be used to implement a second-order 20 MHz filter (e.g., approximately 40 decibels (dB) anti-aliasing at 175 MHz Nyquist frequency).

FIG. 5 is a timing diagram 500 that depicts waveforms 502, 504, 506, 508, 510, 512 associated with the level-shifter LPF circuit 303 of FIG. 3. For example, the waveforms 502, 504, 506, 508, 510, 512 can illustrate nodes VCloutP 340 and VCloutN 344 of FIG. 3 charging nodes Vx_P 232 and Vx_N 234 of FIGS. 2 and/or 3 to the differential input (e.g., RXINP-RXINN) with a desired output common mode (e.g., RX_INCM 236) in two exemplary cycles (e.g., two exemplary clock cycles).

In the illustrated example, a first waveform 502 may represent a voltage of PHI1 334 of FIG. 3 with respect to time and a second waveform 504 may represent a voltage of PHI2 336 of FIG. 3 with respect to time. A third waveform 506 is depicted and may represent a voltage at node VClinP 338 of FIG. 3 with respect to time. A fourth waveform 508 is depicted and may represent a voltage at node VClinN 342 of FIG. 3 with respect to time. A fifth waveform 510 is shown and may represent a voltage at node VCloutP 340 of FIG. 3 with respect to time. A sixth waveform 512 is shown and may represent a voltage at node VCloutN 344 of FIG. 3 with respect to time. Further depicted are voltage levels corresponding to RX_INP 208, RX_INN 210, CM_IN 212, and RX_INCM 236 of FIGS. 2 and/or 3.

In example operation, at a first time 514 (identified by T1), PHI1 334 has a falling edge and PHI2 336 has a rising edge. For example, SW1 310, SW2 312, SW5 318, and SW6 320 of FIG. 3 may open at the first time 514 and SW3 314, SW4 316, SW7 322, and SW8 324 of FIG. 3 may close at the first time 514.

In response to the falling and rising edges, the voltage at node VClinP 338 increases from CM_IN 212 and approaches the voltage of RX_INP 208. In response to the voltage at node VClinP 338 increasing, the voltage at node VCloutP 340 increases from RX_INCM 236 to a first voltage level 516 and voltage at the first voltage level 516 is output at node Vx_P 232 of FIGS. 2 and/or 3.

In response to the falling and rising edges, the voltage at node VClinN 342 decreases from CM_IN 212 and approaches the voltage of RX_INN 210. In response to the voltage at node VClinN 342 decreasing, the voltage at node VCloutN 344 decreases from RX_INCM 236 to a second voltage level 518 and voltage at the second voltage level 518 is output at node Vx_N 234 of FIGS. 2 and/or 3. For example, the voltage difference between the first voltage level 516 and the second voltage level 518 may correspond to a difference between Vx_P 232 and Vx_N 234. In some embodiments, when PHI2 336 has a rising edge and/or has a logic high level, the voltage of C2 328 of FIG. 3 and C2 332 of FIG. 3 can be changed and/or updated due to charge-sharing with the second plate of C1 326 (e.g., the plate of C1 326 coupled to SW2 312 and SW4 316 of FIG. 3) and the second plate of C1 328 (e.g., the plate of C1 328 coupled to SW6 320 and SW8 324). In example operation, at a second time 520 (identified by T2), the difference between the voltages at nodes VClinP 338 and VClinN 342 reaches the voltage of the differential signal (RXINP-RXINN). In example operation, at the second time 520, the difference between the voltages at nodes VCloutP 340 and VCloutN 344 reach the voltage of the difference between CM_IN 212 and RX_INCM 236.

In example operation, at a third time 522 (identified by T3), PHI1 334 has a rising edge and PHI2 336 has a falling edge. For example, SW1 310, SW2 312, SW5 318, and SW6 320 may close at the third time 522 and SW3 314, SW4 316, SW7 322, and SW8 324 may open at the third time 522.

In response to the rising and falling edges, the voltage at node VClinP 338 decreases from RX_INP 208 and approaches CM_IN 212. In response to the voltage at node VClinP 338 decreasing, the voltage at node VCloutP 340 decreases towards RX_INCM 236 and the voltage at the node Vx_P 232 is maintained at the first voltage level 516.

In response to the rising and falling edges, the voltage at node VClinN 342 increases from RX_INN 210 and approaches CM_IN 212. In response to the voltage at node VClinN 342 increasing, the voltage at node VCloutN 344 increases towards RX_INCM 236 and the voltage at the node Vx_N 234 is maintained at the second voltage level 518.

In example operation, at a fourth time 524 (identified by T4), PHI1 334 has a falling edge and PHI2 336 has a rising edge. For example, SW1 310, SW2 312, SW5 318, and SW6 320 may open at the fourth time 522 and SW3 314, SW4 316, SW7 322, and SW8 324 may close at the fourth time 524.

In response to the falling and rising edges, the voltage at node VClinP 338 increases from CM_IN 212 and approaches the voltage of RX_INP 208. In response to the voltage at node VClinP 338 increasing, the voltage at node VCloutP 340 increases from the first voltage level 516 to a third voltage level 526 and voltage at the third voltage level 526 is output as the voltage at node Vx_P 232.

In response to the falling and rising edges, the voltage at node VClinN 342 decreases from CM_IN 212 and approaches the voltage of RX_INN 210. In response to the voltage at node VClinN 342 decreasing, the voltage at node VCloutN 344 decreases from the second voltage level 518 to a fourth voltage level 528 and voltage at the fourth voltage level 528 is output as the voltage at node Vx_N 234.

In example operation, at a fifth time 530 (identified by T5), the difference between the voltages at nodes VClinP 338 and VClinN 342 reaches the voltage of the differential signal (RXINP-RXINN). At the fifth time 530, the difference between the voltages at nodes VCloutP 340 and VC1outN344 reaches the voltage of the differential signal (RXINP-RXINN) and is output as the voltage between nodes Vx_P 232 and Vx_N 234.

In the illustrated example, the nodes VCIoutP 340 and VCIoutN 344 charge the nodes Vx_P 232 and Vx_N 234 to the differential input (RXINP-RXINN) with a desired output common mode represented by RX_INCM 236 in two cycles. Alternatively, the number of clock cycles to charge the Vx_P 232 and Vx_N 234 nodes to the differential input (RXINP-RXINN) can be based on the ratio of the capacitances of C1 326, 330 and C2 328, 332 of FIG. 3.

In example operation, at a sixth time 532 (identified by T6), PHI1 334 has a rising edge and PHI2 336 has a falling edge. For example, SW1 310, SW2 312, SW5 318, and SW6 320 may close at the sixth time 532 and SW3 314, SW4 316, SW7 322, and SW8 324 may open at the sixth time 532.

In response to the rising and falling edges, the voltage at node VClinP 338 decreases from RX_INP 208 and approaches CM_IN 212. In response to the voltage at node VClinP 338 decreasing, the voltage at node VCIoutP 340 decreases towards RX_INCM 236 and the voltage at the node Vx_P 232 is maintained at the third voltage level 526.

In response to the rising and falling edges, the voltage at node VClinN 342 increases from RX_INN 210 and approaches CM_IN 212. In response to the voltage at node VClinN 342 increasing, the voltage at node VCIoutN 344 increases towards RX_INCM 236 and the voltage at the node Vx_N 234 is maintained at the fourth voltage level 528.

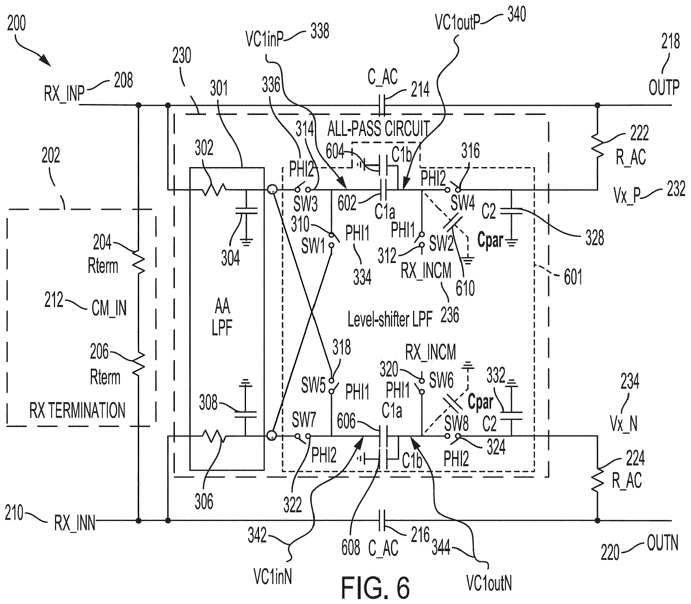

FIG. 6 is a schematic illustration of another example implementation of the AC coupling circuit 200 of FIG. 2. For example, the AC coupling circuit 200 depicted in FIG. 6 includes the anti-aliasing low-pass filter 301 of FIG. 3 and another example implementation of a level-shifter LPF circuit 601. In some embodiments, the level-shifter LPF circuit 601 can implement the switched-capacitor signal-processing circuit 240 of FIG. 2. The level-shifter LPF circuit 601 of FIG. 6 includes the switches 310, 312, 314, 316, 318, 320, 322, 324 and C2 328, 332 of FIG. 3. The level-shifter LPF circuit 601 of this example splits C1 326, 330 of FIG. 3 into at least two capacitors, C1a 602, 606 and C1b 604, 608 which is described below.

In some embodiments, a parasitic capacitance 610 (identified by Cpar) may exist in connection with a second plate of C1 326 (e.g., the plate of C1 326 coupled to SW2 312 and SW4 316, the plate of C1 330 coupled to SW6 320 and SW8 324). In some embodiments, the parasitic capacitance 610 may introduce input signal attenuation and degrade signal quality of the differential signal. For example, the parasitic capacitance 610 may be degrade the differential signal as represented by the example of Equation (7) below:

$$Vx\_P - Vx\_N = C1/(C1 + Cpar) * (RX\_INP - RX\_INN), Equation\ (7)$$

In the example of Equation (7) above, the term "C1/(C1+Cpar)" is an attenuation factor that may cause a mismatch between high-frequency and low-frequency components of the differential signal.

The level-shifter LPF circuit 601 of the illustrated example can be configured to utilize a differential sampling technique on the input signals 208, 210. Beneficially, the differential sampling technique and the splitting of C1 326 of FIG. 3 into multiple capacitors as illustrated in FIG. 6 can overcome the effects of the parasitic capacitance 610. In some embodiments, the differential sampling technique can enable the selection of the splitting ratio of C1 such that the parasitic capacitance may be canceled out and/or otherwise reduced to maintain a relatively flat frequency response. For example, a flat response may correspond to a low-frequency gain matching and/or otherwise closely tracking a high-frequency gain.

In the illustrated example, the differential sampling technique can be implemented by coupling RX_INP 208 to SW3 314 and SW5 318 and by coupling RX_INN 210 to SW1 310 and SW7 322. In the illustrated example, C1 326 of FIG. 3 is split into C1a 602 and C1b 604 and C1 330 is split into C1a 606 and C1b 608. In some embodiments, C1a 602 and C1a 606 have the same capacitance while in other embodiments they may have different capacitances. In some embodiments, C1b 604 and C1b 608 have the same capacitance while in other embodiments they may have different capacitances.

Beneficially, the selection of a ratio of C1a/C1b can control (e.g., precisely control) the DC-coupling path gain (e.g., the DC-coupling path gain of (Vx_P-Vx_N) / (RX_INP-RX_INN)) as illustrated in the example of Equation (8) below:

$$Vx\_P - Vx\_N = 2 * (RX\_INP - RX\_INN) * \left(\frac{C1a}{C1a+C1b+Cpar}\right), Equation\ (8)$$

In the example of Equation (8) above, for Cpar = 0, C1a=C1b provides an ideal 0 dB gain. For Cpar > 0, C1a and C1b can be selected such that C1a> C1b and C1a=C1b+Cpar to obtain 0 dB gain. Beneficially, the splitting of C1326 into C1a 602 and C1b 604 (and the splitting of C1 330 into C1a 606 and C1b 608) provides gain control that may be tuned to cancel out the attenuation factor arising from Cpar 610.

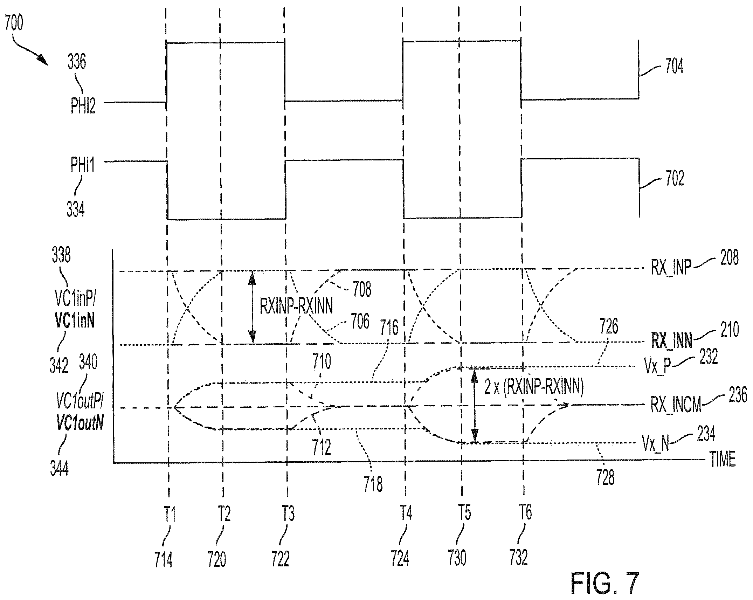

FIG. 7 is a timing diagram 700 that depicts waveforms 702, 704, 706, 708, 710, 712 associated with the level-shifter LPF circuit 601 of FIG. 6. For example, the waveforms 702, 704, 706, 708, 710, 712 may illustrate nodes VCIoutP 340 and VCIoutN 344 of FIG. 6 charging nodes Vx_P 232 and Vx_N 234 of FIGS. 2 and/or 6 to the differential input (e.g., RXINP-RXINN) with a desired output common mode (e.g., RX_INCM 236) in two exemplary cycles (e.g., two exemplary clock cycles).

In the illustrated example, a first waveform 702 may represent PHI1 334 of FIGS. 3 and/or 6 with respect to time and a second waveform 704 may represent PHI2 336 of FIGS. 3 and/or 6 with respect to time. A third waveform 706 is depicted and may represent a voltage at node VCIinP 338 of FIGS. 3 and/or 6 with respect to time. A fourth waveform 708 is depicted and may represent a voltage at node VCIinN 342 of FIGS. 3 and/or 6 with respect to time. A fifth waveform 710 is shown and may represent a voltage at node VCIoutP 340 of FIGS. 3 and/or 6 with respect to time. A sixth waveform 712 is shown and may represent a voltage at node VCIoutN 344 of FIGS. 3 and/or 6 with respect to time. Further depicted are voltage levels corresponding to RX_INP 208, RX_INN 210, and RX_INCM 236 of FIGS. 2, 3, and/or 6.

In example operation, at a first time 714 (identified by T1), PHI1 334 has a falling edge and PHI2 336 has a rising edge. For example, SW1 310, SW2 312, SW5 318, and SW6 320 of FIGS. 3 and/or 6 may open at the first time 714 and SW3 314, SW4 316, SW7 322, and SW8 324 of FIGS. 3 and/or 6 may close at the first time 714.

In response to the falling and rising edges, the voltage at node VCIinP 338 increases from RX_INN 210 and approaches the voltage of RX_INP 208, which contrasts the timing diagram 500 of FIG. 5. For example, in the timing diagram 500 of FIG. 5, the voltage at node VCIinP 338 increases from CM_IN 212 at the first time 514. For example, the utilization of differential sampling as shown in FIG. 6 causes the voltage at VCIinP 338 to charge to the input opposite polarity, such as by alternating between RX_INP 208 and RX_INN 210. In response to the voltage at node VCIinP 338 increasing, the voltage at node VCIoutP 340 increases from RX_INCM 236 to a first voltage level 716 and voltage at the first voltage level 716 is output at node Vx_P 232 of FIGS. 2 and/or 6.

In response to the falling and rising edges, the voltage at node VCIinN 342 decreases from RX_INP 208 and approaches the voltage of RX_INN 210, which contrasts the timing diagram 500 of FIG. 5. For example, in the timing diagram 500 of FIG. 5, the voltage at node VCIinN 342 decreases from CM_IN 212 at the first time 514. For example, the utilization of differential sampling as shown in FIG. 6 causes the voltage at VCIinN 342 to alternate between RX_INN 210 and RX_INP 208. In response to the voltage at node VCIinN 342 decreasing, the voltage at node VCIoutN 344 decreases from RX_INCM 236 to a second voltage level 718 and voltage at the second voltage level 718 is output at node Vx_N 234. In example operation, at a second time 720 (identified by T2), the difference between the voltages at nodes VCIinP 338 and VCIinN 342 reaches the voltage of the differential signal (RXINP-RXINN).

In example operation, at a third time 722 (identified by T3), PHI1 334 has a rising edge and PHI2 336 has a falling edge. For example, SW1 310, SW2 312, SW5 318, and SW6 320 may close at the third time 722 and SW3 314, SW4 316, SW7 322, and SW8 324 may open at the third time 722.

In response to the rising and falling edges, the voltage at node VCIinP 338 decreases from RX_INP 208 and approaches RX_INN 210, which contrasts the timing diagram 500 of FIG. 5. For example, in the timing diagram 500 of FIG. 5, the voltage at node VCIinP 338 decreases from RX_INP 208 and approaches CM_IN 212 at the first time 514. In response to the voltage at node VCIinP 338 decreasing, the voltage at node VCIoutP 340 decreases towards RX_INCM 236 and the voltage at the node Vx_P 232 is maintained at the first voltage level 716.

In response to the rising and falling edges, the voltage at node VCIinN 342 increases from RX_INN 210 and approaches RX_INP 208, which contrasts the timing diagram 500 of FIG. 5. For example, in the timing diagram 500 of FIG. 5, the voltage at node VCIinN 342 increases from RX_INN 210 and approaches CM_IN 212 at the third time 522. In response to the voltage at node VCIinN 342 increasing, the voltage at node VCIoutN 344 increases towards RX_INCM 236 and the voltage at the node Vx_N 234 is maintained at the second voltage level 718.

In example operation, at a fourth time 724 (identified by T4), PHI 1334 has a falling edge and PHI2 336 has a rising edge. For example, SW1 310, SW2 312, SW5 318, and SW6 320 may open at the fourth time 724 and SW3 314, SW4 316, SW7 322, and SW8 324 may close at the fourth time 724.

In response to the falling and rising edges, the voltage at node VCIinP 338 increases from RX_INN 210 and approaches the voltage of RX_INP 208, which contrasts the timing diagram 500 of FIG. 5. For example, in the timing diagram 500 of FIG. 5, the voltage at node VCIinP 338 increases from CM_IN 212 at the fourth time 524. In response to the voltage at node VCIinP 338 increasing, the voltage at node VCIoutP 340 increases from the first voltage level 716 to a third voltage level 726 and a voltage at the third voltage level 726 is output as the voltage at node Vx_P 232.

In response to the falling and rising edges, the voltage at node VCIinN 342 decreases from RX_INP 208 and approaches the voltage of RX_INN 210, which contrasts the timing diagram 500 of FIG. 5. For example, in the timing diagram 500 of FIG. 5, the voltage at node VCIinN 342 decreases from CM_IN 212 at the fourth time 724. In response to the voltage at node VCIinN 342 decreasing, the voltage at node VCIoutN 344 decreases from the second voltage level 718 to a fourth voltage level 728 and a voltage at the fourth voltage level 728 is output as the voltage at node Vx_N 234.

In example operation, at a fifth time 730 (identified by T5), the difference between the voltages at nodes VCIinP 338 and VCIinN 342 reaches the voltage of the differential signal (RXINP-RXINN). At the fifth time 730, the difference between the voltages at nodes VCIoutP 340 and VCIoutN 344 reaches the voltage of 2*(RXINP-RXINN) and is output as the voltage between nodes Vx_P 232 and Vx_N 234. For example, during PHI2 336, the nodes VClinP 338 and VClinN 342 can transfer twice the voltage input step to the nodes of VCIoutP 340 and VCIoutN 344. Reaching the voltage of 2*(RXINP-RXINN) contrasts the timing diagram 500 of FIG. 5 in which the difference between the voltages at nodes VCIoutP 340 and VCIoutN 344 reaches (RXINP-RXINN).

In the illustrated example, the nodes VCIoutP 340 and VCIoutN 344 charge the nodes Vx_P 232 and Vx_N 234 to 2*(RXINP-RXINN) with a desired output common mode represented by RX_INCM 236 in two cycles. Alternatively, the number of clock cycles to charge the Vx_P 232 and Vx_N 234 nodes to the differential input (RXINP-RXINN) can be based on the ratio of the capacitances of C1a 602, 606 and C1b 604, 608 and C2 328 of FIG. 6.

In example operation, at a sixth time 732 (identified by T6), PHI1 334 has a rising edge and PHI2 336 has a falling edge. For example, SW1 310, SW2 312, SW5 318, and SW6 320 may close at the sixth time 732 and SW3 314, SW4 316, SW7 322, and SW8 324 may open at the sixth time 732.

In response to the rising and falling edges, the voltage at node VClinP 338 decreases from RX_INP 208 and approaches RX_INN 210, which contrasts the timing diagram 500 of FIG. 5. For example, in the timing diagram 500 of FIG. 5, the voltage at node VClinP 338 decreases from RX_INP 208 and approaches CM_IN 212 at the sixth time 532. In response to the voltage at node VClinP 338 decreasing, the voltage at node VCIoutP 340 decreases towards RX_INCM 236 and the voltage at the node Vx_P 232 is maintained at the third voltage level 726.

In response to the rising and falling edges, the voltage at node VClinN 342 increases from RX_INN 210 and approaches RX_INP 208, which contrasts the timing diagram 500 of FIG. 5. For example, in the timing diagram 500 of FIG. 5, the voltage at node VClinN 342 increases from RX_INN 210 and approaches CM_IN 212 at the sixth time 532. In response to the voltage at node VClinN 342 increasing, the voltage at node VCIoutN 344 increases towards RX_INCM 236 and the voltage at the node Vx_N 234 is maintained at the fourth voltage level 728.

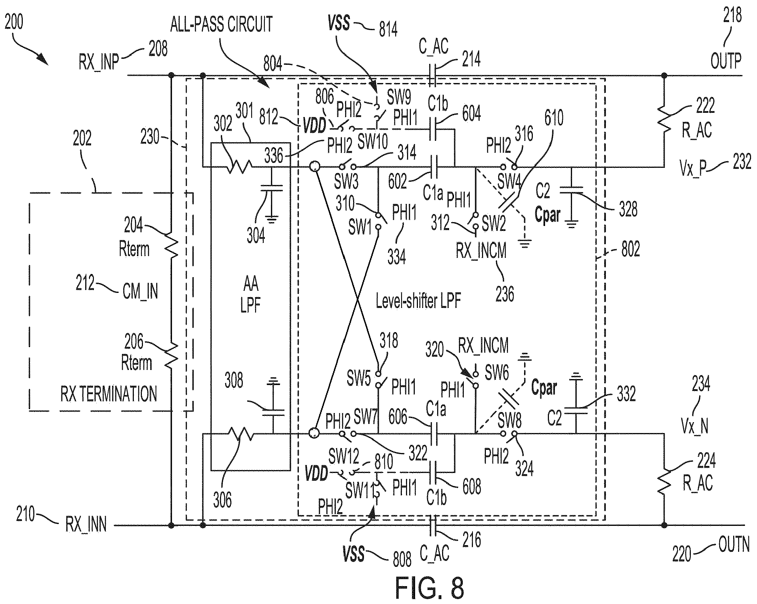

FIG. 8 is a schematic illustration of another example implementation of the AC coupling circuit 200 of FIG. 2. For example, the AC coupling circuit 200 depicted in FIG. 8 includes the anti-aliasing low-pass filter 301 of FIG. 3 and yet another example implementation of a level-shifter LPF circuit 802. In some embodiments, the level-shifter LPF circuit 802 can implement the switched-capacitor signal-processing circuit 240 of FIG. 2.

The level-shifter LPF circuit 802 of FIG. 8 includes the switches 310, 312, 314, 316, 318, 320, 322, 324 and C2 328, 332 of FIG. 3. The level-shifter LPF circuit 802 includes C1a 602, 606 and C1b 604, 608 of FIG. 6. In some embodiments, the level-shifter LPF circuit 802 implements the differential sampling technique shown in FIG. 6.

In some embodiments, the level-shifter LPF circuit 802 can be configured to implement positive-charge pumps. For example, the level-shifter LPF circuit 802 can be configured to include C1b 604, 608 as a positive-charge pump such that the common mode of OUTP/N 218, 220 can achieve voltages greater than a supply voltage.

In the illustrated example, C1b 604 is coupled to a ninth switch 804 (identified by SW9) and a tenth switch 806 (identified by SW10) to implement a positive-charge pump. C1b 608 is coupled to an eleventh switch 808 (identified by SW11) and a twelfth switch 810 (identified by SW12) to implement another positive charge-pump. In some embodiments, SW9 804, SW10 806, SW11 808, and SW12 810 are implemented by transistors. In the illustrated example, SW9 804 and SW11 808 are controlled by PHI1 334 and SW10 806 and SW12 810 are controlled by PHI2 336.

Beneficially, the positive charge pumps can result in the output common mode, which may be represented by the common mode of OUTP 218 and OUTN 220, to reach voltages greater than a supply voltage 812 (identified by VDD). Such a result may be represented by the example of Equation (9) below:

$$OUTP/N\_CM = RX\_INCM + VDD * C1b/(C1a + C1b + Cpar), Equation\ (9)$$

In example operation, during PHI1 334, SW9 804 is closed and SW10 806 is open, which causes a reference voltage 814 (identified by VSS), which is less than VDD 812, to be applied to C1b 604, 608. The voltage across C1b 604, 608 may be represented by RX_INCM 236 because RX_INCM 236 is applied to first ones of the plates of C1b 604, 608 and VSS 814 is applied to second ones of the plates of C1b 604, 608, opposite the first ones.

In example operation, during PHI2 336, SW9 804 is open and SW10 806 is closed, which causes VDD 812 to be applied to C1b 604, 608. The positive-charge pumps add a voltage corresponding to the term "VDD*C1b/(C1a+C1b+Cpar)" of Equation (9) above to RX_INCM 236 to thereby reach a voltage greater than VDD 812.

Beneficially, a lower voltage architecture (e.g., a lower swing voltage architecture) may be used for generation of RX_INCM 236 and the level-shifter LPF circuit 802 may reach at least VDD 812 because the output common mode can result in voltages greater than VDD 812. In some embodiments, a lower (e.g., a negative) DC common mode may be implemented if C1b 604, 608 are configured as negative-charge pumps.

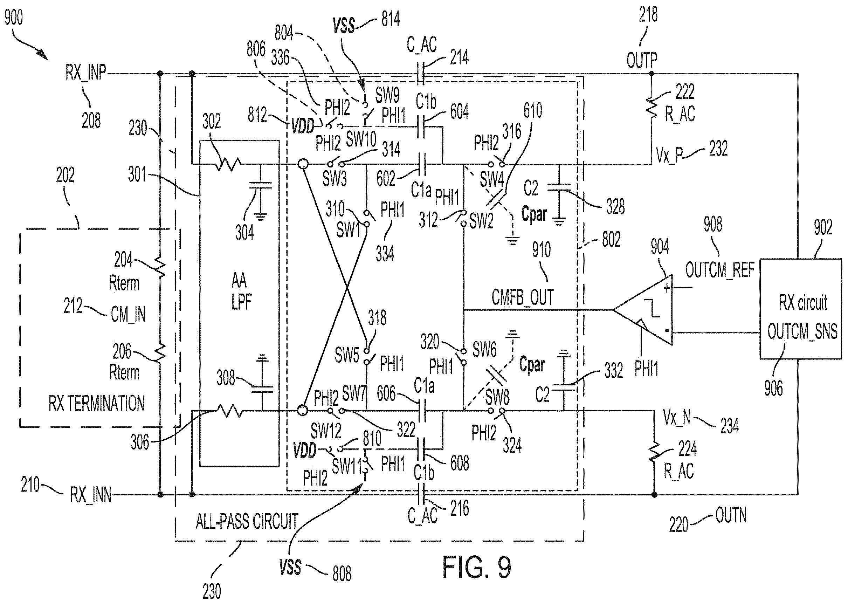

FIG. 9 is a schematic illustration of another example implementation of the AC coupling circuit 110 of FIG. 1 and/or the AC coupling circuit 200 of FIG. 2. For example, FIG. 9 depicts an AC coupling circuit 900 that includes the anti-aliasing low-pass filter 301 of FIG. 3, the level-shifter LPF circuit 802 of FIG. 8, a receiver (RX) circuit 902, and a comparator 904.

In some embodiments, the RX circuit 902 is a circuit that receives the output signals 218, 220 and decodes (e.g., translates) them into a form that can drive additional circuitry. For example, the RX circuit 902 may be an Ethernet receiver circuit that translates the output signals 218, 220 into digital zeros or ones, which may be output to a computer-hardware processor.

In some embodiments, the AC coupling circuit 900 can be configured to implement and/or perform discrete-time common-mode feedback. For example, the AC coupling circuit 900 can implement a common-mode feedback loop, which includes at least the RX circuit 902 and the comparator 904, to operate as a first-order Sigma-Delta modulator.

By way of example, the RX circuit 902 can receive the output signals 218, 220 and sense (e.g., determine) an output common mode based on the output signals 218, 220. The RX circuit 902 can generate a sense signal 906 (identified by OUTCM_SNS) based on the output common mode. For example, the sense signal 906 can represent the sensed output common mode voltage of the RX circuit 902. The RX circuit 902 can output OUTCM_SNS 906 to a first input (identified by a negative sign of the comparator 904 in FIG. 9) (e.g., a first comparator input) of the comparator 904. The comparator 904 can compare OUTCM_SNS 906 to a reference signal 908 (identified by OUTCM_REF) at a second input (identified by a positive sign of the comparator 904 in FIG. 9) (e.g., a second comparator input) of the comparator 904. In the illustrated example, OUTCM_REF 908 is an output common mode reference signal, which can represent a desired (e.g., an ideal) output common mode of the RX circuit 902. For example, OUTCM_REF 908 can represent a target output common mode voltage for operation of the RX circuit 902.

In the illustrated example, the comparator 904 is a clocked comparator. In some embodiments, the comparator 904 is clocked at SC_freq. For example, the comparator 904 can be clocked at a clock input of the comparator 904 using PHI1 334, which may change signal magnitudes at a frequency of SC_freq. In example operation, during PHI1 334, the comparator 904 can compare OUTCM_SNS 906 and OUTCM_REF 908 and output a feedback signal 910 (identified by CMFB_OUT) to the level-shifter LPF circuit 802. In this example, CMFB_OUT 910 is a common mode feedback output signal, which can indicate whether OUTCM_SNS 906 is greater than or less than a target output common mode of the RX circuit 902.

The comparator 904 can feedback a logic level of VDD 812 or VSS 814 at CMFB_OUT 910. For example, the comparator 904 can output a logic level of VDD 812 from a comparator output of the comparator 904 in response to a determination that OUTCM_REF 908 is greater than OUTCM_SNS 906. In some embodiments, the comparator 904 can output a logic level of VSS 814 in response to a determination that OUTCM_REF 908 is less than OUTCM_SNS 906. Beneficially, in some embodiments, the rail-to-rail CMFB_OUT 910 logic level transitions can be filtered by the bandwidths of the filters implemented by the level-shifter LPF circuit 802 and/or the AC coupling filter (e.g., the filter implemented by C_AC 214 and R_AC 222, the filter implemented by C_AC 216 and R_AC 224).

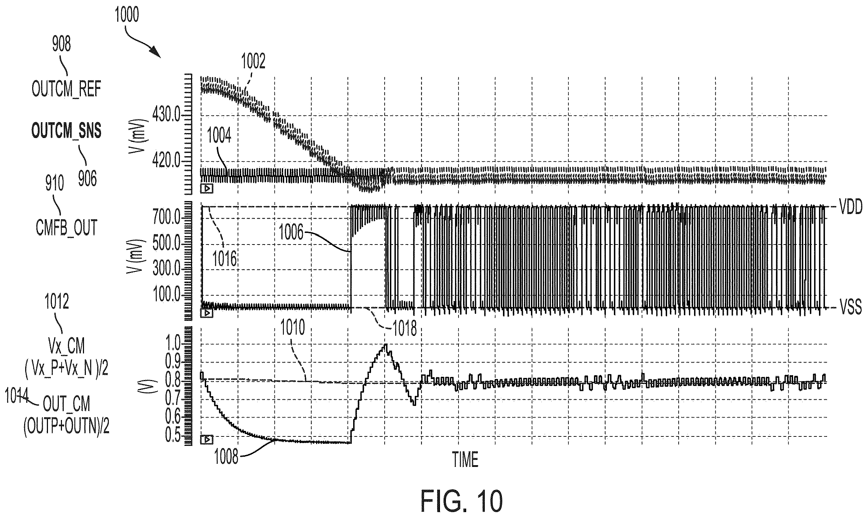

FIG. 10 is a timing diagram 1000 that depicts example waveforms 1002, 1004, 1006, 1008, 1010 associated with the AC coupling circuit 900 of FIG. 9. For example, the waveforms 1002, 1004, 1006, 1008, 1010 can represent transient waveforms depicting the settling behavior of the common-mode feedback loop of FIG. 9 operating as a first-order Sigma-Delta modulator.

In the illustrated example, a first waveform 1002 is depicted and can represent OUTCM_SNS 906 of FIG. 9 with respect to time. A second waveform 1004 is depicted and can represent OUTCM_REF 908 of FIG. 9 with respect to time. A third waveform 1006 is depicted and can represent CMFB_OUT 910 of FIG. 9 with respect to time. A fourth waveform 1008 is depicted and can represent a common mode of the Vx nodes of FIG. 9 (identified by Vx_CM 1012). For example, VX_CM 1012 can represent a voltage determined by half of the sum of Vx_P 232 and Vx_N 234. A fifth waveform 1010 is depicted and can represent an output common mode of the RX circuit 902 of FIG. 9 (identified by OUT_CM 1014). For example, OUT_CM 1014 can represent a voltage determined by half of the sum of OUTP 218 and OUTN 220.

In some embodiments, the comparator 904 of FIG. 9 can compare OUTCM_SNS 906 and OUTCM_REF 908 and output CMFB_OUT 910 based on the comparison. For example, CMFB_OUT 910 can be updated to VDD 1016 or VSS 1018 every cycle based on the comparison. In the illustrated example, CMFB_OUT 910 is updated to VDD 1016 after a determination that OUTCM_REF 908 is greater than OUTCM_SNS 906. In the illustrated example, CMFB_OUT 910 is updated to VSS 1018 after a determination that OUTCM_REF 908 is less than OUTCM_SNS 906.

In the illustrated example, the settling behavior of Vx_CM 1012 can be the result of the filters implemented by the ratio of C1a 602 and C1b 604 and C2 328 (or the ratio of C1a 606 and C1b 608 and C2 332). For example, Vx_CM 1012 can settle to approximately OUT_CM 1014 over time. Beneficially, further filtering is achieved at the output nodes (OUTP 218 and OUTN 220) because of the AC coupling circuit cut-off frequency (e.g., f_AC implemented by C_AC 214 and R_AC 222, f_AC implemented by C_AC 216 and R_AC 224).

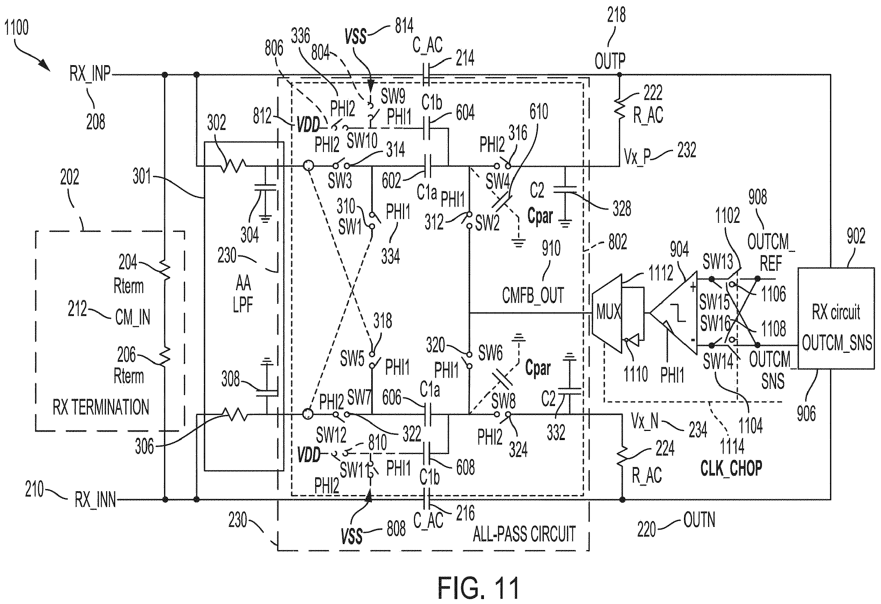

FIG. 11 is a schematic illustration of another example implementation of the AC coupling circuit 110 of FIG. 1 and/or the AC coupling circuit 200 of FIG. 2. For example, FIG. 11 depicts an AC coupling circuit 1100 that includes the anti-aliasing low-pass filter 301 of FIG. 3, the level-shifter LPF circuit 802 of FIG. 8, the RX circuit 902 and the comparator 904 of FIG. 9, a thirteenth switch 1102 (identified by SW13), a fourteenth switch 1104 (identified by SW14), a fifteenth switch 1106 (identified by SW15), a sixteenth switch 1108 (identified by SW16), an inverter 1110, and a multiplexer 1112. In some embodiments, SW13 1102, SW14 1104, SW15 1106, and/or SW16 1108 can be implemented by transistors. In the illustrated example, SW13 1102 and SW14 1104 have non-inverting inputs (e.g., non-inverting terminals) and SW15 1106 and SW16 1108 have inverting inputs (e.g., inverting terminals).

In some embodiments, the comparator 904 can be relatively low powered because noise that may be introduced in the AC coupling circuit 1100 by the comparator 904 is heavily filtered by f_SC and f_AC. In some embodiments, the comparator 904 can have an offset that may introduce an offset in the common mode feedback loop. Beneficially, the AC coupling circuit 1100 of the illustrated example can be configured to overcome and/or correct the offset in the common mode feedback loop that may be introduced by the comparator 904. For example, an offset mitigation technique such as chopping may be utilized.

In the illustrated example, the AC coupling circuit 1100 can be configured to use chopping by swapping inputs to the comparator 904 every cycle. In this example, a chop (or chopping) clock 1114 (identified by CLK_CHOP) can control SW13 1102, SW14 1104, SW15 1106, and SW16 1108. For example, during a first chopping clock cycle of CLK_CHOP 1114, SW13 1102 and SW14 1104 can close and SW15 1106 and SW16 1108 can open. In this example, OUTCM_REF 908 can be provided to the positive input of the comparator 904 and OUTCM_SNS 906 can be provided to the negative input of the comparator 904. During a second chopping clock cycle after the first chopping clock cycle, SW13 1102 and SW14 1104 can open and SW15 1106 and SW16 1108 can close. In this example, OUTCM_REF 908 can be provided to the negative input of the comparator 904 and OUTCM_SNS 906 can be provided to the positive input of the comparator 904.

In some embodiments, the output of the comparator 904 can be inverted to maintain comparator polarity. In the illustrated example, the output of the comparator 904 is provided to a first input (e.g., a first multiplexer input) of the multiplexer 1112 and an inverter input of the inverter 1110. An inverter output of the inverter 1110 is coupled to a second input (e.g., a second multiplexer input) of the multiplexer 1112. The multiplexer 1112 is clocked at a clock input of the multiplexer 1112 to CLK_CHOP 1114 such that the multiplexer 1112 alternates between outputting the first input or the second input as CMFB_OUT 910. For example, an output (e.g., a multiplexer output) of the multiplexer 1112 can output either the first input or the second input every clock cycle to correspond to a polarity associated with the comparator 904. Beneficially, the offset that may be introduced by the comparator 904 is modulated and/or removed by CLK_CHOP 1114 and filtered by f_SC and f_AC.

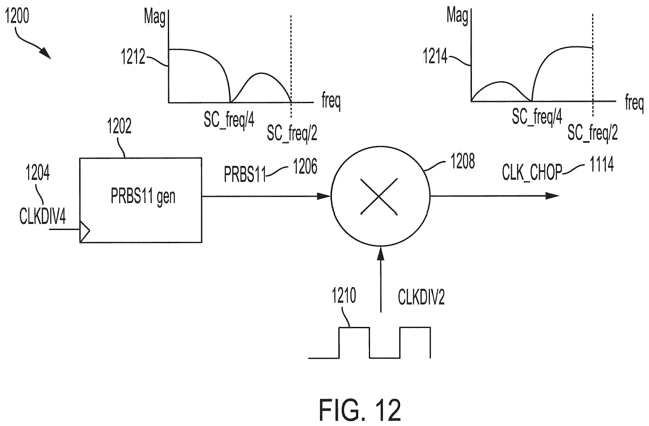

FIG. 12 is a schematic illustration of an example implementation of a clock circuit 1200 to perform a chopping modulation technique. In some embodiments, the clock circuit 1200 can generate CLK_CHOP 1114 of FIG. 11. The clock circuit 1200 of the illustrated example is implemented at least in part by a pseudorandom binary sequence (PRBS) generator 1202. In some embodiments, the PRBS generator 1202 may be implemented by one or more analog circuits, one or more digital circuits, and/or one or more ICs, such as being implemented by PRBS generation circuitry.

The PRBS generator 1202 of this example receives a first divided clock signal 1204 (identified by CLKDIV4) and generates a PRBS signal 1206 (identified by PRBS 11) based on the first divided clock signal 1204. The PRBS generator 1202 of this example is an 11-bit PRBS generator that is configured to generate the PRBS signal 1206 as an 11-bit PRBS pattern at a quarter rate of SC_freq. For example, the quarter rate of SC_freq can be achieved by dividing SC_freq by 4 to yield CLKDIV4 1204. Alternatively, the PRBS generator 1202 may be configured to generate the PRBS signal 1206 using any other pattern and/or at any other rate.

In the illustrated example, the PRBS generator 1202 outputs the PRBS signal 1206 to a multiplier 1208 to multiply the PRBS signal 1206 and a second clock signal 1210 to generate CLK_CHOP 1114. For example, the multiplier 1208 can be configured such that the PRBS signal 1206 is up-modulated by a "1,+1" clock pattern at SC_freq/2 to output CLK_CHOP 1114. In some embodiments, the multiplier 1208 may be implemented by one or more analog circuits, one or more digital circuits, and/or one or more ICs, such as being implemented by multiplication circuitry (e.g., voltage multiplication circuitry).

In some embodiments, the clock circuit 1200 can perform the chopping modulation technique to spread portion(s) of the offset power between the frequencies of SC_freq/4 and SC_freq/2, which can be filtered by the f_SC and f_AC filters as described herein. For example, PRBS 11 1206 may have an associated frequency response 1212 as shown in FIG. 12, which plots the magnitude of PRBS11 1206 as a function of frequency. In the frequency response 1212, the offset power is greater in the frequency range of 0 to SC_freq/4 than in the frequency range of SC_freq/4 to SC_freq/2. In some embodiments, CLK_CHOP 1114 may have an associated frequency response 1214 as shown in FIG. 12, which plots the magnitude of CLK_CHOP 1114 as a function of frequency. In the frequency response 1214, the offset power is greater in the frequency range of SC_freq/4 to SC_freq_2 than in the frequency range of 0 to SC_freq/4. Beneficially, the chopping modulation technique can spread the offset power between the frequencies SC_freq/4 to SC_freq/2 to facilitate their filtering by the f_SC and f_AC filters.

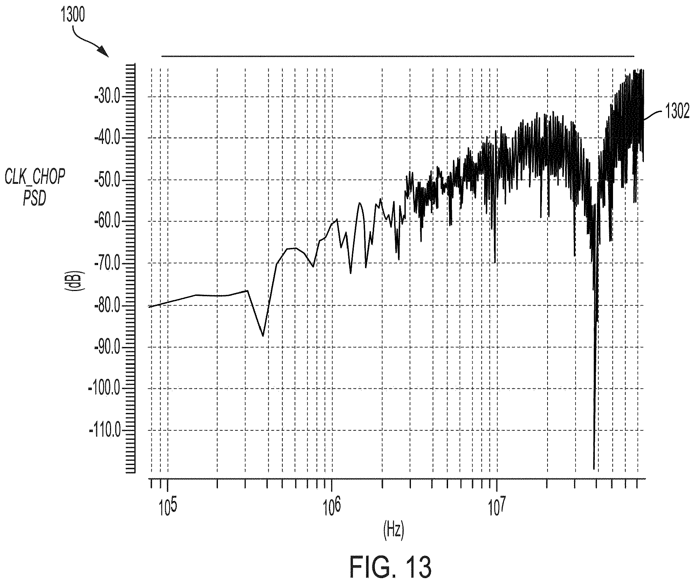

FIG. 13 is a plot 1300 that depicts a waveform 1302 representing a power spectral density (PSD) of CLK_CHOP 1114 of FIGS. 11 and/or 12 with respect to frequency measured in hertz (Hz). Beneficially, low-frequency power is substantially suppressed by having a PSD of approximately -80db and the power of CLK_CHOP 1114 is spread at the higher frequencies.

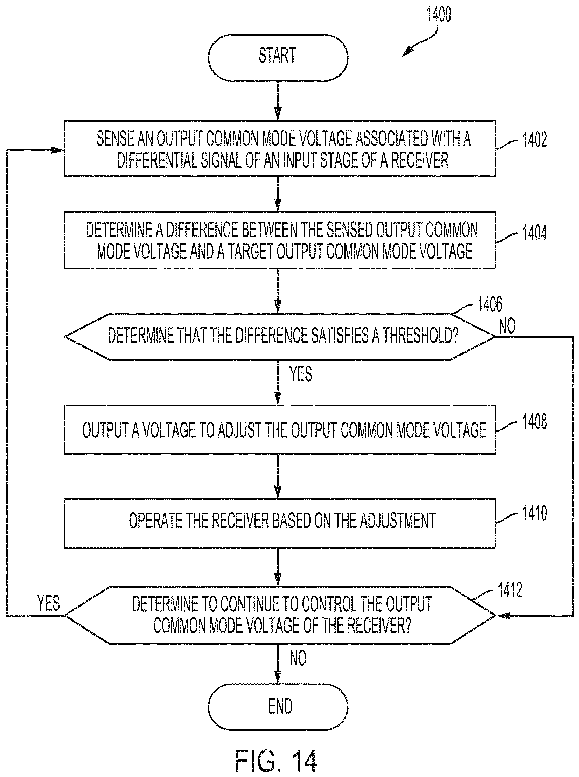

FIG. 14 is a flowchart 1400 of an example method to output a differential signal to a receiver input stage of a receiver. The flowchart 1400 begins at block 1402, at which a receiver system, such as the receiver system 100 of FIG. 1, can sense an output common mode voltage associated with a differential signal of an input stage of a receiver. For example, the RX circuit 902 of FIGS. 9 and/or 11 can sense the output common mode voltage and output the sensed voltage as OUTCM_SNS 906.

At block 1404, the receiver system can determine a difference between the sensed output common mode voltage and a target output common mode voltage. For example, the comparator 904 of FIGS. 9 and/or 11 can determine whether OUTCM_REF 908 is greater than or less than OUTCM_SNS 906 based on the difference thereof.

At block 1406, the receiver system can determine whether the difference satisfies a threshold. For example, the comparator 904 can determine that the difference between OUTCM_REF 908 and OUTCM_SNS 906 is a positive voltage and thereby satisfies a comparison threshold of the comparator 904 to output CMFB_OUT 910 as VDD 812. In some embodiments, the comparator 904 can determine that the difference between OUTCM_REF 908 and OUTCM_SNS 906 is a negative voltage and thereby does not satisfy the comparison threshold of the comparator 904 to output CMFB_OUT 910 as VSS 814.

If, at block 1406, the receiver system determines that the difference does not satisfy the threshold, control proceeds to block 1412. Otherwise, control proceeds to block 1408. At block 1408, the receiver system outputs a voltage to adjust the output common mode voltage. For example, the comparator 904 can output CMFB_OUT 910 as VDD 812 to be injected into Vx_P 232 and Vx_N 234 and adjust Vx_CM 1012 of FIG. 12 by increasing Vx_CM 1012. In response to increasing Vx_CM 1012, OUT_CM 1014 can be adjusted (e.g., increased) to ensure proper operation of the RX circuit 902.

At block 1410, the receiver system can operate the receiver based on the adjustment. For example, the RX circuit 902 can be operated (e.g., continue to be operated) using the adjusted output common mode voltage.

At block 1412, the receiver system can determine whether to continue to control the output common mode voltage of the receiver. For example, the receiver system may continue to control the output common mode voltage of the receiver while the receiver system is powered and/or enabled. If, at block 1412, the receiver system determines to continue to control the output common mode voltage of the receiver, control returns to block 1402. Otherwise, the method represented by the flowchart 1400 of FIG. 14 concludes.

Having thus described several aspects of at least one embodiment of this disclosure, it is to be appreciated that various alterations, modifications, and improvements will readily occur to those skilled in the art.

Such alterations or modifications are intended to be part of this disclosure and are intended to be within the spirit and scope of the disclosure. Further, though advantages of the present disclosure are indicated, it should be appreciated that not every embodiment of the disclosure will include every described advantage. Some embodiments may not implement any features described as advantageous herein. Accordingly, the foregoing description and drawings are by way of example only.

Various aspects of the present disclosure may be used alone, in combination, or in a variety of arrangements not specifically discussed in the embodiments described in the foregoing and is therefore not limited in its application to the details and arrangement of components set forth in the foregoing description or illustrated in the drawings. For example, aspects described in one embodiment may be combined in any manner with aspects described in other embodiments.

Use of ordinal terms such as "first," "second," "third," etc., in the claims to modify a claim element does not by itself connote any priority, precedence, or order of one claim element over another or the temporal order in which acts of a method are performed, but are used merely as labels to distinguish one claim element having a certain name from another element having a same name (but for use of the ordinal term) to distinguish the claim elements.

All definitions, as defined and used herein, should be understood to control over dictionary definitions, and/or ordinary meanings of the defined terms.

The indefinite articles "a" and "an," as used herein in the specification and in the claims, unless clearly indicated to the contrary, should be understood to mean "at least one."

As used herein in the specification and in the claims, the phrase "at least one," in reference to a list of one or more elements, should be understood to mean at least one element selected from any one or more of the elements in the list of elements, but not necessarily including at least one of each and every element specifically listed within the list of elements and not excluding any combinations of elements in the list of elements. This definition also allows that elements may optionally be present other than the elements specifically identified within the list of elements to which the phrase "at least one" refers, whether related or unrelated to those elements specifically identified.

The phrase "and/or," as used herein in the specification and in the claims, should be understood to mean "either or both" of the elements so conjoined, i.e., elements that are conjunctively present in some cases and disjunctively present in other cases. Multiple elements listed with "and/or" should be construed in the same fashion, i.e., "one or more" of the elements so conjoined. Other elements may optionally be present other than the elements specifically identified by the "and/or" clause, whether related or unrelated to those elements specifically identified. Thus, as a non-limiting example, a reference to "A and/or B", when used in conjunction with open-ended language such as "comprising" can refer, in one embodiment, to A only (optionally including elements other than B); in another embodiment, to B only (optionally including elements other than A); in yet another embodiment, to both A and B (optionally including other elements); etc.

As used herein in the specification and in the claims, "or" should be understood to have the same meaning as "and/or" as defined above. For example, when separating items in a list, "or" or "and/or" shall be interpreted as being inclusive, i.e., the inclusion of at least one, but also including more than one, of a number or list of elements, and, optionally, additional unlisted items. Only terms clearly indicated to the contrary, such as "only one of" or "exactly one of," or, when used in the claims, "consisting of," will refer to the inclusion of exactly one element of a number or list of elements. In general, the term "or" as used herein shall only be interpreted as indicating exclusive alternatives (i.e., "one or the other but not both") when preceded by terms of exclusivity, such as "either," "one of," "only one of," or "exactly one of." "Consisting essentially of," when used in the claims, shall have its ordinary meaning as used in the field of patent law.

Also, the phraseology and terminology used herein is for the purpose of description and should not be regarded as limiting. The use of "including," "comprising," or "having," "containing," "involving," and variations thereof herein, is meant to encompass the items listed thereafter and equivalents thereof as well as additional items.

**Claims**

1.   An apparatus comprising:

an anti-aliasing circuit configured to reduce a bandwidth of a first differential signal received from a termination circuit of a receiver; and
a switched-capacitor circuit coupled to an output of the anti-aliasing circuit, the switched-capacitor circuit configured to:

control a first switch to charge a capacitor to a first voltage, wherein the first voltage is based on a first difference between a common mode input voltage and a common mode reference voltage, the common mode input voltage associated with a first common mode voltage of the first differential signal, the common mode reference voltage associated with a second common mode voltage of an input stage of the receiver;
control a second switch to provide a second voltage to the capacitor, the second voltage based on a second difference between the first differential signal and the common mode input voltage; and
output a second differential signal to the input stage of the receiver, the second differential signal based on the first differential signal adjusted by the second voltage.

2.   The apparatus of claim 1, wherein:

the controlling of the first switch to charge the capacitor to the first voltage comprises turning on the first switch at a first time and turning off the second switch at the first time; and
the controlling of the second switch to provide the second voltage to the capacitor comprises turning off the first switch at a second time, after the first time, and turning on the second switch at the second time.

3.   The apparatus of claim 1 or 2, wherein the first switch is coupled to a first terminal of the capacitor, and the apparatus further comprising:

a third switch coupled to a second terminal of the capacitor; and
a comparator comprising a clock input, a first comparator input, a second comparator input, and a comparator output, the clock input is configured to receive a clock signal, the first comparator input is configured to receive a reference voltage, the second comparator input is configured to receive a sensed output common mode voltage of the input stage of the receiver, and the comparator output is coupled to the third switch, and the comparator is configured to:

compare the sensed output common mode voltage and the reference voltage; and
generate the common mode reference voltage in response to the clock signal and a determination that the sensed output common mode voltage satisfies the reference voltage.

4. The apparatus of claim 3, wherein the controlling of the first switch to charge the capacitor to the first voltage is in response to the clock signal.

5. The apparatus of claim 3 or 4, further comprising:

a third switch coupled to the first comparator input and configured to receive the reference voltage;
a fourth switch coupled to the first comparator input and having a first inverting terminal and configured to receive the sensed output common mode voltage;
a fifth switch coupled to the second comparator input and configured to receive the reference voltage;
a sixth switch coupled to the second comparator input and having a second inverting terminal configured to receive the sensed output common mode voltage; and
a clock circuit coupled to the third switch, the fourth switch, the fifth switch, and the sixth switch.

6. The apparatus of claim 5, wherein the clock circuit is configured to:

generate a first clock signal to control the third switch, the fourth switch, the fifth switch, and the sixth switch to cause the first comparator input to receive the reference voltage and the second comparator input to receive the sensed output common mode voltage; and
generate a second clock signal, after the first clock signal, to control the third switch, the fourth switch, the fifth switch, and the sixth switch to cause the first comparator input to receive the sensed output common mode voltage and the second comparator input to receive the reference voltage;
wherein the clock circuit is configured to generate the first clock signal and the second clock signal based on a pseudorandom binary sequence pattern.

7. The apparatus of claim 1, further comprising:

a comparator comprising a first comparator input, a second comparator input, and a comparator output, the first comparator input coupled to an output of the input stage of the receiver, and respective signals of the first comparator input and the second comparator input are to be swapped every clock cycle;
an inverter comprising an inverter input and an inverter output, the inverter input coupled to the comparator output; and
a multiplexer comprising a first multiplexer input, a second multiplexer input, and a multiplexer output, the first multiplexer input coupled to the comparator output, the second multiplexer output coupled to the inverter output, and the multiplexer output coupled to the first switch, and the multiplexer is configured to:

select the first multiplexer input or the second multiplexer input every clock cycle to correspond to a polarity associated with the comparator; and
output the selected one of the first multiplexer input or the second multiplexer input to the first switch.

8. The apparatus of any preceding claim, wherein the capacitor is a first capacitor, and the apparatus further comprising:

a second capacitor comprising a first terminal and a second terminal, the second terminal coupled to the first capacitor in parallel;
a third switch coupled to the first terminal, the third switch configured to provide a third voltage to the second capacitor, and the first switch and the third switch are configured to be turned on in response to a first clock signal; and
a fourth switch coupled to the first terminal, the fourth switch configured to provide a fourth voltage to the second capacitor, the fourth voltage greater than the third voltage, and the second switch and the fourth switch are configured to be turned on in response to a second clock signal after the first clock signal.

9. The apparatus of any preceding claim, the apparatus further comprising at least one of the following:

the second switch is to provide the second voltage to cause rejection of the common mode input voltage;
an all-pass filter comprises the anti-aliasing circuit and the switched-capacitor circuit;
the anti-aliasing circuit comprises a low-pass filter; and
the switched-capacitor circuit comprises a level-shifter low-pass filter.

10. An apparatus comprising:

coil circuitry configured to receive a first differential signal;

input stage circuitry; and

alternating current coupling circuitry coupled to an output of the coil circuitry, the alternating current coupling circuitry configured to:

charge a capacitor to a first voltage, the first voltage based on a first difference between a common mode input voltage and a common mode reference voltage, the common mode input voltage associated with a first common mode voltage of the first differential signal, the common mode reference voltage associated with a second common mode voltage of the input stage circuitry;

provide a second voltage to the capacitor, the second voltage based on a second difference between the first differential signal and the common mode input voltage; and

output a second differential signal to the input stage circuitry, the second differential signal adjusted by the second voltage; and wherein

the input stage circuitry is configured to convert the second differential signal to a third differential signal.

11. The apparatus of claim 10, further comprising receiver termination circuitry, and the alternating current coupling circuitry is coupled to the coil circuitry through the receiver termination circuitry.

12. The apparatus of claim 10 or 11, wherein the coil circuitry comprises:

a first inductor configured to receive a first signal based on a first polarity;

a second inductor coupled to the first inductor and the alternating current coupling circuitry through the receiver termination circuitry;

a third inductor configured to receive a second signal based on a second polarity, opposite the first polarity; and

a fourth inductor coupled to the third inductor and the alternating current coupling circuitry through the receiver termination circuitry.

13. The apparatus of any of claims 10 to 12, wherein the capacitor is a first capacitor, and the receiver termination circuitry comprises:

a first resistor comprising a first resistor terminal and a second resistor terminal, the first resistor terminal coupled to the output of the coil circuitry;

a second resistor comprising a third resistor terminal and a fourth resistor terminal, the third resistor terminal coupled to the output of the coil circuitry and the second resistor terminal of the first resistor; and

a second capacitor comprising a first capacitor terminal and a second capacitor terminal, the first capacitor terminal coupled to the second resistor terminal of the first resistor and the fourth resistor terminal of the second resistor;

wherein the input stage circuitry comprises a differential amplifier.

14. A method comprising:

sensing an output common mode voltage associated with a differential signal of an input stage of a receiver;

determining a difference between the sensed output common mode voltage and a target output common mode voltage;

determining whether the difference satisfies a threshold; and

in response to determining that the difference satisfies the threshold, outputting a voltage to an all-pass circuit to adjust the output common mode voltage.

15. The method of claim 14, further comprising:

comparing the sensed output common mode voltage and the target output common mode voltage to determine the difference; and

generating the voltage based on a first rail voltage in response to determining that the difference represents that the sensed output common mode voltage is greater than the target output common mode voltage.

FIG. 1

EP 4 366 163 A2

FIG. 2

EP 4 366 163 A2

FIG. 3

FIG. 4

FIG. 5

FIG. 6

EP 4 366 163 A2

FIG. 7

FIG. 8

FIG. 9

FIG. 10

FIG. 11

FIG. 12

FIG. 13

1400

START

SENSE AN OUTPUT COMMON MODE VOLTAGE ASSOCIATED WITH A
DIFFERENTIAL SIGNAL OF AN INPUT STAGE OF A RECEIVER — 1402

DETERMINE A DIFFERENCE BETWEEN THE SENSED OUTPUT COMMON
MODE VOLTAGE AND A TARGET OUTPUT COMMON MODE VOLTAGE — 1404

DETERMINE THAT THE DIFFERENCE SATISFIES A THRESHOLD? — 1406    NO

YES

OUTPUT A VOLTAGE TO ADJUST THE OUTPUT COMMON MODE VOLTAGE — 1408

OPERATE THE RECEIVER BASED ON THE ADJUSTMENT — 1410

YES    DETERMINE TO CONTINUE TO CONTROL THE OUTPUT
COMMON MODE VOLTAGE OF THE RECEIVER? — 1412

NO

END

FIG. 14